# FASCICULE DE BREVET EUROPEEN

(11) **EP 0 549 434 B1**
(45) Date de publication et mention de la délivrance du brevet: **26.03.1997**
(21) Numéro de dépôt: 92403467.1
(22) Date de dépôt: 21.12.1992
(51) Int. Cl.: H03M 9/00

(54) **Convertisseur série-parallèle et parallèle-série photonique**
Photonischer Parallel-Seriell- und Seriell-Parallel-Umsetzer
Photonic serial to parallel and parallel to serial converter

(30) Priorité: 27.12.1991 FR 9116237
(43) Date de publication de la demande: 30.06.1993
(73) Titulaire: ALCATEL CIT, 75008 Paris (FR)
(72) Inventeur: Gabriagues, Jean-Michel, F-91530 Le Val Saint Germain (FR); Le Roy, Guy, F-22300 Lannion (FR)
(74) Mandataire: Sciaux, Edmond

(56) Documents cités:
- WO-A-86/05309
- WO-A-87/05454
- US-A- 3 354 451
- IBM TECHNICAL DISCLOSURE BULLETIN. vol. 14, no. 8, Décembre 1971, NEW YORK US pages 2208 - 2209 CALLAHAN 'optical delay line compressor'

## Description

La présente invention concerne un dispositif photonique pour le traitement de signaux optiques binaires à fréquence déterminée.

Dans l'état actuel des technologies optiques, on connaît deux classes de dispositifs, à savoir :
- des dispositifs d'optique guidée à une ou deux dimensions, représentés, respectivement, par les fibres optiques et les circuits intégrés planaires, ces dispositifs étant destinés à assurer la propagation et le routage d'informations réparties dans le temps;
- des dispositifs de traitement photonique à une ou deux dimensions, représentés, respectivement, par des barrettes ou réseaux linaires et des matrices, ces dispositifs étant constitués d'éléments photoniques bi-stables, destinés à assurer chacun la mémorisation d'une information élémentaire, physiquement représentée par une quantité d'énergie optique reçue, puis ré-émise.

Le document US 3 354 451 décrit un dispositif de conversion parallèle-série et un dispositif de conversion série-parallèle, permettant de transmettre des données binaires en série sur une onde porteuse optique. Chacun de ces dispositifs de conversion comporte une série de portes optiques commandées séquentiellement par une même impulsion électrique retardée par une ligne à retard constituée par une paire d'électrodes parallèles communes à toutes les portes. Chaque porte est constituée par : un segment d'un barreau de matériau électro-optique situé entre ces deux électrodes, un segment d'une lame polariseur, et un segment d'une lame analyseur.

La présente invention vise à fournir un dispositif permettant la combinaison ou le raccordement de ces deux classes de dispositifs, en réalisant un circuit d'interface optique permettant de traiter un flux d'informations, par exemple pour le convertir d'un flux de type série en un flux de type parallèle, ou vice-versa, ou pour obtenir un retard variable des informations élémentaires. L'invention se propose, en outre, de fournir un dispositif réalisable avec les technologies utilisables pour les circuits intégrés photoniques, à savoir les semi-conducteurs de type III-V et les circuits passifs en silice sur substrat silicium ou en polymères sur substrat quelconque.

A cet effet, le dispositif selon l'invention est caractérisé en ce qu'il comporte un circuit optique intégré planaire comportant :
- un chemin optique comportant une pluralité de guides passifs couplés en série et une pluralité d'éléments amplificateurs optiques semi-conducteurs intercalés périodiquement entre les guides;
- des accès d'entrée-sortie du dispositif, disposés le long de ce chemin optique avec des intervalles tels que les durées de propagation entre deux accès successifs soient identiques entre eux et correspondent à la fréquence de bit des signaux binaires.

Un tel dispositif peut être agencé pour constituer un registre à décalage série-parallèle ou parallèle-série, ou encore une ligne à retard variable.

Les caractéristiques et les avantages de l'invention seront mieux compris à la lumière de la description d'une forme de réalisation, indiquée à titre d'exemple et représentée dans le dessin annexé, dans lequel :

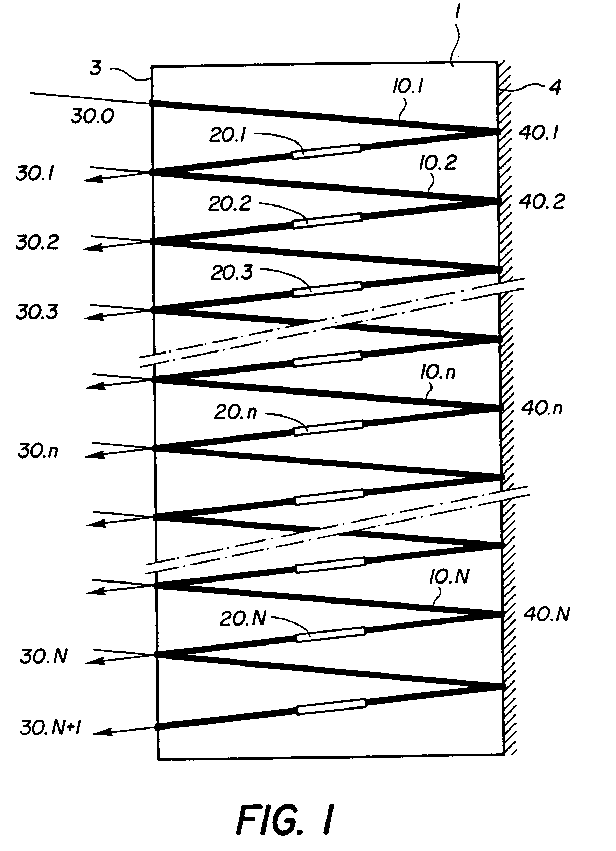

La figure 1 montre, schématiquement, un dispositif selon l'invention.

La figure 1 présente un mode de réalisation exploitant les techniques connues d'intégration ou d'hybridation optique. Le dispositif comporte un substrat 1 portant des guides passifs 10.n (n = 1,2, ...N) interconnectant des éléments amplificateurs 20.n intégrés ou hybridés sur le substrat. Le trajet optique est replié sur lui-même, de la façon représentée à la figure 1, où les points 30.0 et 30.N+1 désignent respectivement l'entrée et la sortie principales du circuit. Les points 30.1 à 30.N sont N sorties ou entrées intermédiaires de ce circuit.

L'onde optique se propageant à l'intérieur de ce dispositif rencontre, entre deux éléments amplificateurs consécutifs, deux interfaces matériau-air 30.n et 40.n La face 4 du substrat correspondant à l'interface 40.n est revêtue d'un traitement optique réfléchissant, de sorte que l'énergie de l'onde optique est très peu affectée par ses multiples réflexions sur cette face. La face opposée 3 du substrat, correspondant aux entrées et sorties 30.n, présente un coefficient de réflexion déterminé de façon qu'une partie de l'énergie de l'onde optique émerge du circuit, tandis que le reste de l'énergie continue à se propager dans celui-ci. Ceci peut être réalisé soit par le facteur de réflexion spéculaire intrinsèque au matériau, soit par un traitement réflecteur partiel adapté. Les éléments amplificateurs 20.n présentent un gain compensant les pertes par propagation et réflexion subies par l'onde le long du trajet optique entre deux entrées et sorties consécutives.

Pour un fonctionnement du dispositif comme registre à entrée série et sortie parallèle, l'information véhiculée par l'onde couplée à l'entrée 30.0 est supposée conditionnée en motifs de N bits, N étant le nombre de sorties intermédiaires du circuit. L'onde optique se propage de l'entrée 30.0 vers la sortie 30.N+1 en passant par toutes les sorties intermédiaires 30.n. Si T est le temps bit, c.à.d. la durée de l'information binaire élémentaire, on disposera, avec une période égale à N x T, du contenu du motif de N bits réparti au même instant sur les différentes sorties 30.1 à 30.N, c.à.d. en parallèle.

Dans un mode de fonctionnement à entrée parallèle et sortie série, on peut présenter, à un instant donné, à chaque entrée 30.1 à 30.N une information optique codée de durée égale à T et collecter, à la sortie 30.N+1, la totalité des informations appliquées sous la forme d'un motif de N bits consécutifs.

Le dispositif peut également être utilisé comme ligne à retard variable, en collectant l'information série à une des sorties intermédiaires, donc avec un retard par rapport à l'instant d'entrée dans le circuit, qui est proportionnel au numéro d'ordre de la sortie intermédiaire considérée.

Il est à noter que le présent dispositif est accordé par sa construction. Le temps de propagation des signaux entre des entrées et/ou sorties consécutives doit, en effet, être identique et correspondre à la valeur de la fréquence d'horloge des informations optiques binaires à traiter. A titre d'exemple, si le débit binaire est égal à 2,5 Gbit/s, le trajet optique est caractérisé par une période de 35 mm environ pour un circuit réalisé sur substrat de phosphure d'indium. La fréquence d'accord peut être ajustée finement en réglant la température de fonctionnement du circuit, étant donné que l'indice de réfraction qui détermine la vitesse de propagation des ondes optiques varie avec la température suivant des lois connues.

## Revendications

1. Dispositif photonique pour le traitement de signaux optiques binaires ayant une fréquence de bit déterminée, caractérisé en ce qu'il comporte un circuit intégré optique planaire (1) comportant :
- un chemin optique comportant une pluralité de guides passifs (101, ..., 10.N) couplés en série et une pluralité d'éléments amplificateurs optiques semi-conducteurs (20.1, ..., 20.N) intercalés périodiquement entre les guides;
- des accès d'entrée-sortie (30.0, ..., 30.N+1) du dispositif, disposés le long de ce chemin optique avec des intervalles tels que les durées de propagation entre deux accès successifs soient identiques entre eux et correspondent à la fréquence de bit des signaux binaires.

2. Dispositif selon la revendication 1, caractérisé en ce que le chemin optique est replié sur lui-même entre deux faces opposées (3,4) du substrat du circuit intégré (1), les entrées et sorties (30.n) du dispositif étant disposées le long d'une face (3) du substrat, et une face opposée (4) de ce substrat étant munie d'un revêtement réfléchissant.

3. Dispositif selon la revendication 1, caractérisé en ce qu'il est agencé pour constituer un registre à décalage série-parallèle.

4. Dispositif selon la revendication 1, caractérisé en ce qu'il est agencé pour constituer un registre à décalage parallèle-série.

5. Dispositif selon la revendication 1, caractérisé en ce qu'il est agencé pour constituer une ligne à retard variable.

## Patentansprüche

1. Photonische Vorrichtung für die Verarbeitung von binären optischen Signalen mit einer bestimmten Bitfrequenz, dadurch gekennzeichnet, daß sie eine planare, optische, integrierte Schaltung (1) enthält,
- mit einem optischen Pfad, der mehrere passive und in Reihe gekoppelte Lichtleiter (10.1, 10.N) und mehrere periodisch zwischen diese Lichtleiter eingefügte halbleitende, optische Verstärkerelemente (20.1, .. 20.N) enthält,
- mit Eingangs-Ausgangs-Zugängen (30.0, .. 30.N+1) der Vorrichtung, die entlang des optischen Pfads in solchen Abständen angeordnet sind, daß die Ausbreitungsdauer zwischen zwei aufeinanderfolgenden Zugängen gleich ist und der Bitfrequenz der binären Signale entspricht.

2. Vorrichtung nach Anspruch 1, dadurch gekennzeichnet, daß der optische Pfad mehrfach zwischen zwei einander gegenüberliegenden Seiten (3, 4) des Substrats der integrierten Schaltung (1) gefaltet ist, wobei die Eingänge und Ausgänge (30.n) der Vorrichtung entlang einer Seite (3) des Substrats liegen und eine entgegengesetzte Seite (4) dieses Substrats mit einer reflektierenden Beschichtung versehen ist.

3. Vorrichtung nach Anspruch 1, dadurch gekennzeichnet, daß sie als Schieberegister mit Serieneingang und parallelen Ausgängen ausgebildet ist.

4. Vorrichtung nach Anspruch 1, dadurch gekennzeichnet, daß sie als Schieberegister mit parallelen Eingängen und einem Serienausgang ausgebildet ist.

5. Vorrichtung nach Anspruch 1, dadurch gekennzeichnet, daß sie als Verzögerungsleitung mit variabler Verzögerung ausgebildet ist.

## Claims

1. A photonic device for processing binary optical signals of determined bit frequency, said device being characterized in that it comprises a planar integrated optics circuit (1) comprising:
an optical path comprising a plurality of passive waveguides (101, 10.N) coupled in series, and a plurality of semiconductor optical amplifier elements (20.1, ..., 20.N) interposed periodically between the waveguides; and
input-output accesses (30.0, ..., 30.N+1) of the device, which accesses are disposed along the optical path at intervals such that the propagation times between two successive accesses are mutually identical and correspond to the bit frequency of the binary signals.

2. A device according to claim 1, characterized in that the optical path zigzags back and forth between two opposite faces (3, 4) of the substrate of the integrated circuit (1), the inputs and outputs (30.n) of the device being disposed along one face (3) of the substrate, and an opposite face (4) of the substrate being provided with a reflective coating.

3. A device according to claim 1, characterized in that it is organized to constitute a serial-to-parallel shift register.

4. A device according to claim 1, characterized in that it is organized to constitute a parallel-to-serial shift register.

5. A device according to claim 1, characterized in that it is organized to constitute a variable delay line.
